# EUROPEAN PATENT APPLICATION

(11) **EP 0 582 486 A2**
(43) Date of publication of application: **09.02.1994**
(21) Application number: 93306222.6
(22) Date of filing: 06.08.1993
(51) Int. Cl.: H01L 27/12, H01L 21/84

(54) **A thin film transistor pair and a process for fabricating the same**

(30) Priority: 07.08.1992 JP 211845/92
(71) Applicant: SHARP KABUSHIKI KAISHA, Osaka 545 (JP)
(72) Inventor: Deguchi, Tsukasa, Tenri-shi, Nara-ken (JP); Tsuchimoto, Shuhei, Kitakatsuragi-gun, Nara-ken (JP); Morita, Tatsuo, Soraku-gun, Kyoto (JP)
(74) Representative: Brown, Kenneth Richard

(57) **Abstract**

A thin film transistor pair including a gate electrode having first and second gate portions and a process for fabricating the same are provided. The process includes forming a source region and a drain region in a first semiconductor layer using a first resist film used for the formation of the first gate portion, and forming a source region and a drain region in a second semiconductor layer using a second resist film used for the formation of the second gate portion. The first and second gate portions may have widened joint portions connected to each other.

## Description

### BACKGROUND OF THE INVENTION

### 1. Field of the Invention:

The present invention relates to a thin film transistor pair and a process for fabricating the same. More particularly, the present invention relates to a thin film transistor pair suitably applied to an active matrix substrate for a liquid crystal display apparatus, an image sensor, and the like, and a process for fabricating the same.

### 2. Description of the Related Art:

An active matrix substrate for a liquid crystal display apparatus and an image sensor are driven by an outer drive circuit. In recent years, there has arisen a need for forming the drive circuit on the active matrix substrate or on a substrate on which the image sensor is formed as an integral part thereof. Such a drive circuit includes a thin film transistor pair (hereinafter referred to as a "TFT pair") having a CMOS structure formed on a transparent insulating substrate.

Figure 5 is a plane view of a conventional TFT pair having a CMOS structure. This TFT pair will be briefly described. Semiconductor layers 21 and 22 are formed on a transparent insulating substrate (not shown). The semiconductor layer 21 includes a p-type source rcgion 21a, a p-type drain region 21b, and an n-type channel region 21c interposed between the source and drain regions 21a and 21b. The semiconductor layer 22 includes an n-type source region 22a, an n-type drain region 22b, and a p-type channel region 22c interposed between the source and drain regions 22a and 22b. Gate electrodes 23 and 24 are formed on a gate insulating film (not shown) covering the semiconductor layers 21 and 22. The gate electrodes 23 and 24 are formed separately, and are electrically isolated from each other. They have been doped with impurity atoms of opposite conductivity types to each other. An interlevel insulating film (not shown) is formed covering the semiconductor layers 21 and 22 and the gate electrodes 23 and 24. The interlevel insulating film has a plurality of contact holes 27 to 32. The contact holes 27 and 28 reach the gate electrodes 23 and 24, respectively. The contact holes 29 and 30 reach the source region 21a and the drain region 21b, respectively. The contact holes 31 and 32 reach the source region 22a and the drain region 22b, respectively. The gate electrodes 23 and 24 are connected to each other through an electrode wiring 33.

The conventional TFT pair having the above structure is fabricated as follows:

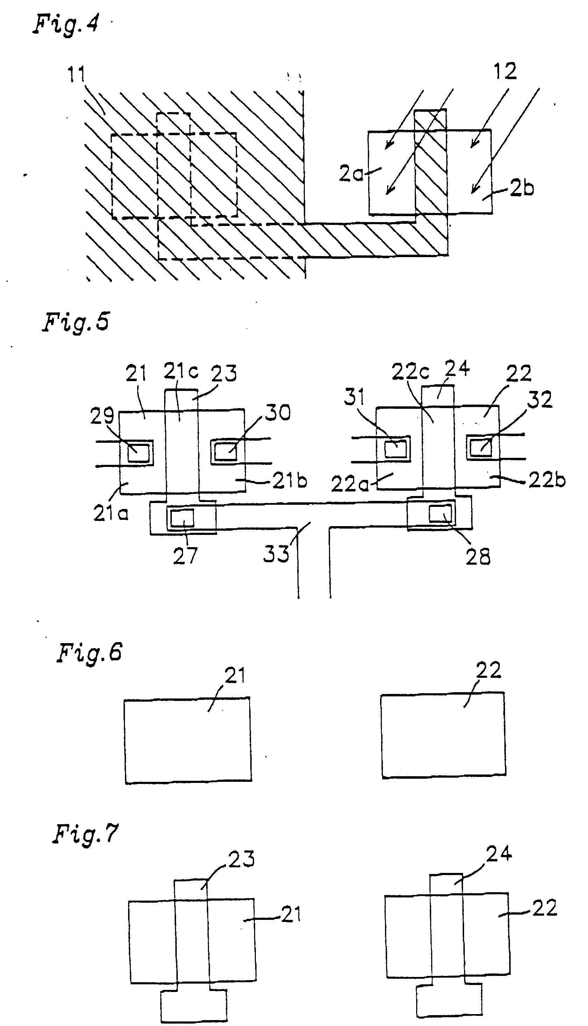

As shown in Figure 6, the semiconductor layers 21 and 22 are formed on the transparent insulating substrate (not shown). The semiconductor layers 21 and 22 are covered with the gate insulating film (not shown). Then, a gate material (not shown) is deposited on the gate insulating film. A resist film (not shown) patterned to cover portions allocated for the gate electrodes 23 and 24 is formed on the gate material. Using the resist film as a mask, the gate material is etched, so that the gate electrodes 23 and 24 are formed as shown in Figure 7. The gate electrodes 23 and 24 are made of undcped polysilicon or metal.

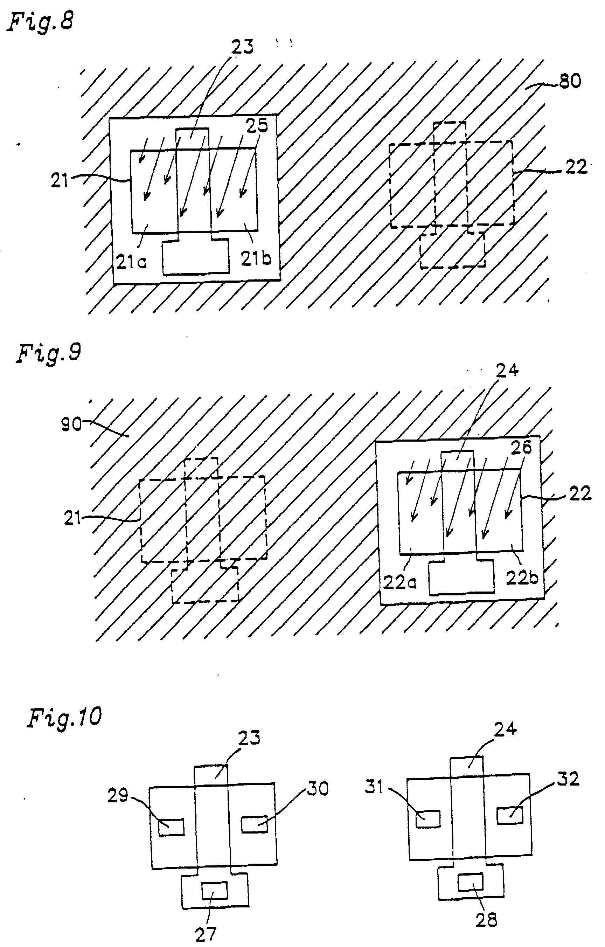

As shown in Figure 8, after the removal of the resist film used for the formation of the gate electrodes 23 and 24, a resist film 80 (shown as the hatched area in Figure 8) is formed so as to cover the semiconductor layer 22. Using the resist film 80 as a mask, the semiconductor layer 21 is doped with p-type impurity atoms 25 by ion implantation or other doping methods, so that the p⁺ -type source region 21a and the p⁺-type drain region 21b are formed. At this doping, the gate electrode 23 is also doped with the p-type impurity atoms 25.

As shown in Figure 9, after the removal of the resist film 80, a resist film 90 (shown as the hatched area in Figure 9)is formed so as to cover the semiconductor layer 21. Using the resist film go as a mask, the semiconductor layer 22 is doped with n-type impurity atoms 26 by ion implantation or other doping methods, so that the n⁺-type source region 22a and the n⁺-type drain region 22b are formed. At this doping, the gate electrode 24 is also doped with the n-type impurity atoms 26. After the removal of the resist film 90, the interlevel insulating film (not shown) is formed covering the semiconductor layers 21 and 22 and the gate electrodes 23 and 24.

Thereafter, as shown in Figure 10, the contact holes 27 to 32 are formed. The contact holes 27 and 28 are formed so as to reach the gate electrodes 23 and 24, respectively. The contact holes 29 and 30 are formed so as to reach the p⁺-type source and drain regions 21a and 21b, respectively. The contact holes 31 and 32 are formed so as to reach the n⁺-type source and drain regions 22a and 22b, respectively. Finally, as shown in Figure 5, the electrode wiring 33 made of metal is formed for connecting the gate electrodes 23 and 24. Thus, the TFT pair having the CMOS structure as shown in Figure 5 is completed.

According to the conventional process for fabricating the TFT pair, after the formation of the gate electrodes on the respective semiconductor layers, the semiconductor layers are individually doped with p-type or n-type impurity atoms using different resist films. Conventionally, the process for fabricating the TFT pair requires at least six photolithographic steps which include patterning or doping by use of a resist film as a mask. These steps include: (1) forming the semiconductor layers, (2) forming the gate electrodes, (3) doping one of the semiconductor layers with the p-type impurity atoms, (4) doping the other semiconductor layer with the n-type impurity atoms, (5) forming the contact holes, and (6) forming the electrode wiring. In general, as the number of photolithographic steps increases, the operation efficiency lowers and the production yield of the resultant TFT pairs lowers. Therefore, the number of photolithographic steps should be as small as possible.

Further, in the conventional TFT pairs, since the gate electrodes are formed separately, different contact holes reaching the respective gate electrodes are required. In general, as the number of contact holes increases, the production yield of the resultant TFT pairs lowers. Therefore, the number of contact holes should be as small as possible.

### SUMMARY OF THE INVENTION

The thin film transistor pair of this invention comprises: a substrate; a first semiconductor layer formed on said substrate, said first semiconductor layer having a source region of a first conductivity type, a drain region of said first conductivity type, and a channel region interposed between said source region and said drain region; a second semiconductor layer formed on said substrate at a position apart from said first semiconductor layer, said second semiconductor layer having a source region of said second conductivity type, a drain region of said second conductivity type, and a channel region interposed between said source region and said drain region; a gate insulating film covering said first semiconductor layer and said second semiconductor layer; and a gate electrode formed on said gate insulating film, said gate electrode having a first gate portion covering said channel region of said first semiconductor layer and a second gate portion covering said channel region of said second semiconductor layer, wherein said first gate portion of said gate electrode has a first joint portion having a width greater than that of the remaining portion of said first gate portion, and said second gate portion of said gate electrode has a second joint portion having a width greater than that of the remaining portion of said second gate portion, said first and second joint portions being connected to each other, and wherein said first gate portion with said first joint portion and said second gate portion with said second joint portion constitute a single continuous layer.

According to another aspect of the present invention, there is provided a thin film transistor pair comprising: a substrate; a first semiconductor layer formed on said substrate, said first semiconductor layer having a source region of a first conductivity type, a drain region of said first conductivity type, and a channel region interposed between said source region and said drain region; a second semiconductor layer formed on said substrate at a position apart from said first semiconductor layer, said second semiconductor layer having a source region of said second conductivity type, drain region of said second conductivity type, and a channel region interposed between said source region and said drain region; a gate insulating film covering said first semiconductor layer and said second semiconductor layer; and a gate electrode formed on said gate insulating film, said gate electrode having a first gate portion covering said channel region of said first semiconductor layer and a second gate portion covering said channel region of said second semiconductor layer, wherein said first gate portion and said second gate portion constitute a single continuous layer, and said gate electrode is made of polysilicon doped with impurity atoms of substantially one of said first conductivity type and said second conductivity type.

According to another aspect of the present invention, there is provided a process for fabricating a thin film transistor pair, said thin film transistor pair including: a substrate; a first semiconductor layer formed on said substrate; a second semiconductor layer formed on said substrate at a position apart from said first semiconductor layer; a gate insulating film covering said first semiconductor layer and said second semiconductor layer; and a gate electrode formed on said gate insulating film, said gate electrode having a first gate portion covering a channel region of said first semiconductor layer and a second gate portion covering a channel region of said second semiconductor layer, said process comprising the steps of: forming said first semiconductor layer and said second semiconductor layer on said substrate; forming said insulating film covering said first semiconductor layer and said second semiconductor layer; forming a gate material film on said gate insulating film; forming a first resist film on said gate material film, said first resist film being patterned to cover a portion allocated for said first gate portion and at least a portion allocated for said second gate portion and said second semiconductor layer; forming said first gate portion by etching said gate material film using said first resist film as a mask; doping a portion of said first semiconductor layer not covered with said first gate portion with impurity atoms of a first conductivity type before the removal of said first resist film so as to form a source region and a drain region in said first semiconductor layer; removing said first resist film; forming a second resist film patterned to cover at least said first gate portion and said first semiconductor layer and a portion allocated for said second gate portion of said gate material film; forming said second gate portion by etching said gate material film using said second resist film as a mask; doping a portion of said second semiconductor layer not covered with said second gate portion with impurity atoms ofa second conductivity type before the removal of said second resist film so as to form a source region and a drain region in said second semiconductor layer; and removing said second resist film.

According to yet another aspect of the present invention, there is provided a process for fabricatinga thin film transistor pair, said thin film transistor pair including: a substrate; a first semiconductor layer formed on said substrate; a second semiconductor layer formed on said substrate at a position apart from said first semiconductor layer; a gate insulating film covering said first semiconductor layer and said second semiconductor layer; and a gate electrode formed on said gate insulating film, said gate electrode having a first gate portion covering a channel region of said first semiconductor layer and a second gate portion covering a channel region of said second semiconductor layer, said process comprising the steps of: forming said first semiconductor layer and said second semiconductor layer on said substrate; forming said insulating film covering said first semiconductor layer and said second semiconductor layer; forming a gate material film on said gate insulating film; forming a first resist film on said gate material film, said first resist film being patterned to cover a portion allocated for said first gate portion and at least a portion allocated for said second gate portion and said second semiconductor layer; forming said first gate portion by etching said gate material film using said first resist film as a mask; removing said first resist film; doping a portion of said first semiconductor layer not covered with said first gate portion with impurity atoms of a first conductivity type after the removal of said first resist film so as to form a source region and a drain region in said first semiconductor layer; forming a second resist film patterned to cover at least said first gate portion and said first semiconductor layer and a portion allocated for said second gate portion of said gate material film; forming said second gate portion by etching said gate material film using said second resist film as a mask; doping a portion of said second semiconductor layer not covered with said second gate portion with impurity atoms of a second conductivity type before the removal of said second resist film so as to form a source region and a drain region in said second semiconductor layer; and removing said second resist film.

Thus, the invention described herein makes possible the advantages of (1) providing a thin film transistor pair fabricated with enhanced production yield by reducing the number of contact holes and the number of photolithographic steps, and (2) providing a process for fabricating such a thin film transistor.

These and other advantages of the present invention will become apparent to those skilled in the art upon reading and understanding the following detailed description with reference to the accompanying figures.

### BRIEF DESCRIPTION OF THE DRAWINGS

Figure 1 is a plan view of a thin film transistor pair of a first example according to the present invention.

Figures 2 to 4 are plan views showing a process for fabricating the thin film transistor pair of Figure 1 according to the present invention.

Figure 5 is a plan view of a conventional thin film transistor pair.

Figures 6 to 10 are plan views showing a conventional process for fabricating the thin film transistor pair of Figure 5.

Figures 11A to 11F are sectional views showing the process for fabricating the thin film transistor pair of Figure 1 according to the present invention.

Figure 12 is a plan view of a modification of the thin film transistor pair of Figure 1 according to the present invention.

Figures 13 and 14 are plan views showing a process for fabricating the thin film transistor pair of Figure 12 according to the present invention.

Figures 15A to 15G are sectional views showing a process for fabricating a thin film transistor pair of a second example according to the present invention.

Figure 16 is a plan view of a thin film transistor pair of a third example according to the present invention.

Figure 17 is a circuit diagram of the thin film transistor pair of Figure 16.

Figures 18A to 18D are sectional views showing a process for fabricating the thin film transistor pair of Figure 16 according to the present invention.

Figures 19A to 19D are sectional views showing a process for fabricating a thin film transistor pair of a fourth example according to the present invention.

### DESCRIPTION OF THE PREFERRED EMBODIMENTS

The present invention will be described by way of example with reference to the attached drawings.

### Example 1

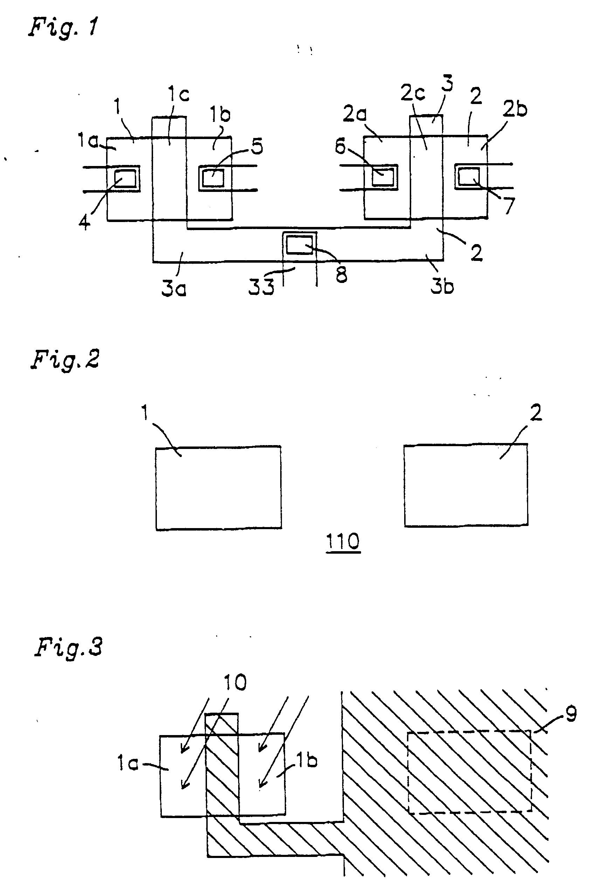

Referring to Figure 1, the structure of the TFT pair of this example will be described. The TFT pair includes semiconductor layers 1 and 2 formed separately on a transparent insulating substrate (not shown) made of glass or the like. The semiconductor layer 1 includes a p-type source region 1a, a p-type drain region 1b, and a channel region 1c inter posed between the source and drain regions 1a and 1b. The semiconductor layer 2 includes an n-type source region 2a, an n-type drain region 2b, and a channel region 2c interposed between the source and drain regions 2a and 2b. A gate electrode 3 is formed on a gate insulating film (not shown) covering the semiconductor layers 1 and 2.

The gate electrode 3 is formed of a polysilicon film doped with substantially either p-type impurity atoms or n-type impurity atoms. The phrase, "a polysilicon film doped with substantially either p-type impurity atoms or n-type impurity atoms" as used herein is defined as allowing the other p-type impurity atoms or n-type impurity atoms to enter the polysilicon film as far as the content thereof is within a predetermined limit. More practically, when the polysilicon film contains second-conductivity type impurity atoms of 25% or less of the dose of first-conductivity type impurity atoms, the inclusion of the second-conductivity type impurity atoms in the polysilicon film is disregarded. This is because such a low-level inclusion does not substantially affect the function of the gate electrode. For example, when the dose of the first-conductivity type impurity atoms is 2 x 10¹⁵ ions/cm², the allowable amount of the second-conductivity type impurity atoms in the polysilicon film is 5 x 14¹⁴ ions/cm².

The gate electrode 3 may be formed of a metal film such as an aluminum film.

The gate electrode 3 includes two gate electrode portions 3a, and 3b. The gate electrode portion 3a covers at least the channel region 1c of the semiconductor layer 1. The gate electrode portion 3b covers at least the channel region 2c of the semiconductor layer 2. The gate electrode portions 3a and 3b constitute a single continuous layer. In the present specification, the term, "a single continuous layer" as used herein is defined as "a spatially continuous layer having substantially identical electrical properties."

In this example, the gate electrode portions 3a and 3b are respectively shaped as the letter L as shown in Figure 1. However, the gate electrode portions 3a and 3b may be in any shape as far as the gate electrode portions 3a and 3b cover at least the channel region 1c of the semiconductor layer 1 and the channel region 2c of the semiconductor layer 2, respectively. For example, they can be shaped as the letter I or U.

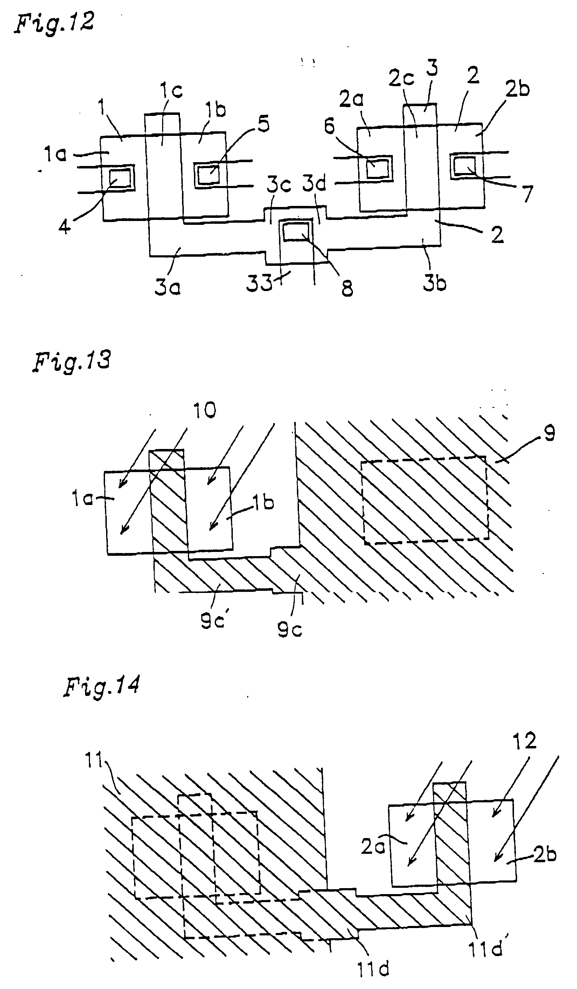

In this example, the width of the gate electrode portions 3a and 3b is uniform over the length thereof as shown in Figure 1. However, it need not be uniform. For example, as shown in Figure 12, joint portions 3c and 3d of the gate electrode portions 3a and 3b, respectively, can be wider than the remaining portions of the gate electrode portions 3a and 3b. This structure will be described later.

An interlevel insulating film (not shown) is formed covering the semiconductor layers 1 and 2 and the gate electrode 3. The interlevel insulating film has a plurality of contact holes 4 to 8. The contact holes 4 and 5 reach the source region 1a and the drain region 41b, respectively. The contact holes 6 and 7 reach the source region 2a and the drain region 2b, respectively. The contact hole 8 reaches the gate electrode 3.

The process for fabricating the TFT pair having the above structure will be described with reference to Figures 2 to 4 and Figures 11A to 11F as follows:

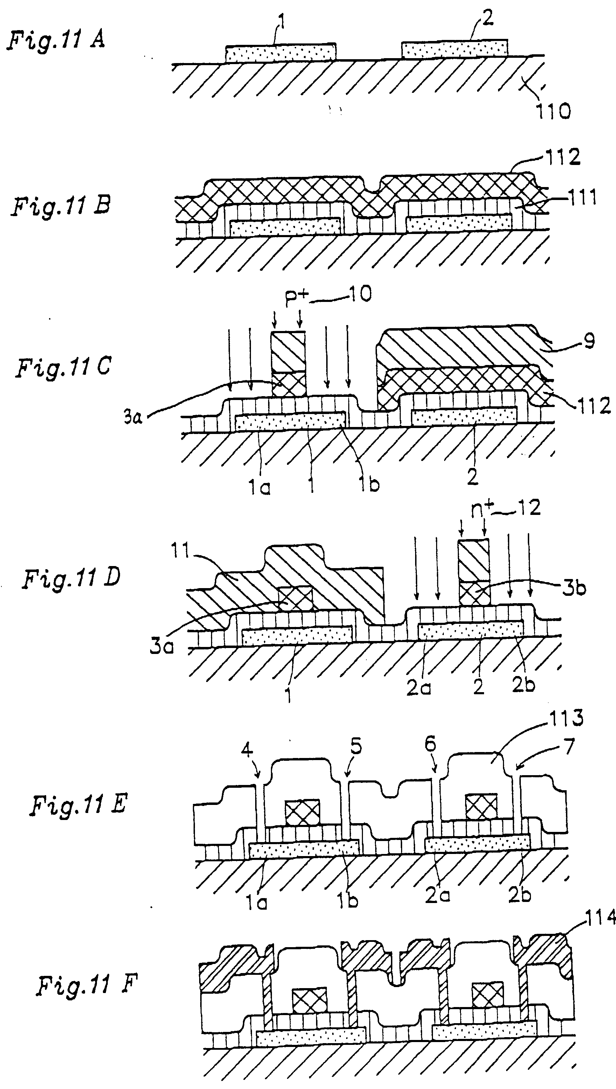

As shown in Figures 2 and 11A, a semiconductor film such as a polysilicon film is formed on a transparent insulating substrate 110 and patterned to form the semiconductor layers 1 and 2 on the transparent insulating substrate 110. The thickness of the semiconductor layers 1 and 2 is 100 nm, for example.

Then, as shown in Figure 11B, the semiconductor layers 1 and 2 are covered with a gate insulating film 111 made of silicon dioxide or other insulators. A gate material film 112 is formed on the gate insulating film 111 by chemical vapor deposition (CVD) or sputtering. The gate material film 112 of this example is made of polysilicon doped with either p-type impurity atoms or n-type impurity atoms.

A resist film 9 is formed on the gate material film 112 and patterned as shown in Figure 3 (hatched area) so as to cover an area allocated for the gate electrode portion 3a and at least an area allocated for the gate electrode portion 3b and the. semiconductor layer 2. The resist film 9 can be formed, for example, by applying a positive resist on the entire surface of the gate material film 112, exposing the resist to light using a mask of the pattern shown by the hatched area in Figure 3, and developing the resist. Then, areas which are not covered with the resist film 9 are completely etched, thus to form the gate electrode portion 3a.

With the resist film 9 kept unremoved, the semiconductor layer 1 is doped with either p-type impurity atoms or n-type impurity atoms by a first ion implantation or doping. For example, as shown in Figure 11C, the semiconductor layer 1 can be doped with p-type impurity atoms 10. As a result, the p⁺-type source region 1a and the p⁺-type drain region 1b are formed. Boron (B⁺) can be used as the p-type impurity atoms 10. The resist film 9 is removed after the first ion implantation or doping.

Thereafter, a resist film 11 is formed on the gate material film 112 and patterned as shown in Figure 4 (hatched area) so as to cover an area allocated for the gate electrode portion 3b and at least the gate electrode portion 3a and the semiconductor layer 1. The resist film 11 can be formed, for example, by applying a positive resist on the entire surface of the gate material film 112, exposing the resist to light using a mask of the pattern shown by the hatched area in Figure 4, and developing the resist. Then, areas which are not covered with the resist film 11 are completely etched, thus to form the gate electrode portion 3b. As a result, the gate electrode portions 3a and 3b are formed as a single continuous layer.

With the resist film 11 kept unremoved, a second ion implantation or doping is conducted in which the semiconductor layer 2 is doped with impurity atoms of the conductivity type different from the one used for the first ion implantation or doping. For example, as shown in Figure 11D, the semiconductor layer 2 can be doped with n-type impurity atoms 12. As a result, the n⁺-type source region 2a and the n⁺-type drain region 2b are formed. Phosphorus (P⁺) can be used as the n-type impurity atoms 12. The resist film 11 is removed after the second ion implantation or doping.

According to the fabricating process or this example, an integrally formed gate electrode is obtained. That is, the gate electrode 3 is formed as a single continuous layer having the gate electrode portions 3a and 3b. By the aforementioned conventional fabricating process, it is difficult to form a TFT pair having such an integrally formed gate electrode made of polysilicon because of the following reasons:

A polysilicon film undoped with impurity atoms has a high resistance. Accordingly, when used as the material for the gate electrode, the polysilicon film needs to be doped with either p-type or n-type impurity atoms. This doping is preferably uniform over the entire polysilicon film. This is because, when the concentration of carriers contained in the gate electrode is not uniform, a p-n junction or a high-resistance portion may be formed in the gate electrode, which causes a problem of low conductivity.

If an integrally formed gate electrode is formed according to the conventional fabricating process, a gate electrode portion for the p-channel TFT is doped with p-type impurity atoms and a gate electrode portion for the n-channel TFT is doped with n-type impurity atoms. This results in that one part of the integrally formed gate electrode is high in the concentration of the p-type impurity atoms and the other part thereof is high in the concentration of the n-type impurity atoms. As a result, a uniform concentration of carriers in the gate electrode is not obtained. Further, depending on the shape of the resist films used at the doping of the impurity atoms, the gate electrode may include portions undoped or doped with both p-type and n-type impurity atoms. This also results in the non-uniform concentration of carriers in the gate electrode. Because of these reasons, it is difficult to obtain an Integrally formed gate electrode for the TFT pair by the conventional fabricating process.

The fabricating process of this example makes it possible to fabricate the TFT pair including the gate electrode made of polysilicon having a structure which can not be obtained by the conventional fabricating process. By integrally forming the gate electrode, it is not necessary to form two contacts as conventionally required for connecting the two electrically-isolated gate electrodes through the metal interconnection. This reduces the number of contacts required for the TFT pair, and as a result lowering of the production yield caused by a contact defect can be prevented.

The fabricating process of this example is also advantageous in that the same resist film used for the formation of the gate electrode can be used for the formation of the source region and the drain region. Moreover, the same resist film used for the formation of the gate electrode can be used to protect the source region and the drain region of one of the conductivity types from being doped with impurities of the other conductivity type. As a result, the three steps in the conventional fabricating process, i.e., (1) formation of the gate electrodes, (2) doping one semiconductor layer with p-type impurity atoms, and (3) doping the other semiconductor layer with n-type impurity atoms, can be simplified into two steps, i.e., (1)' forming part of the gate electrode and doping the semiconductor layer with p-type impurity atoms and (2)' forming the remaining part of the gate electrode and doping the semiconductor layer with n-type impurity atoms.

The above conventional steps (1) to (3) each include one photolithographic process. The steps (1)' and (2)' also each include one photolithographic process. Therefore, according to the fabricating process of this example, one photolithographic process can be eliminated. Reducing the number of photolithographic processes contributes to improving the production yield because of the following reasons:

In the photolithographic process, a defect such as a disconnection and a short-circuit tends to occur due to the attachment of fine particles floating in the air to a mask used at the process. Such a defect is more critical as the width of the interconnection between the electrodes is made smaller. The possibility of the occurrence of such a defect decreases by reducing the number of photolithographic processes. As a result, the production yield improves.

As mentioned earlier, the joint portions 3c and 3d which are end portions of the gate electrode portions 3a and 3b, respectively, for connecting to each other have preferably a greater width than the remaining portions of the gate electrode portions 3a and 3b, as shown in Figure 12. By forming such wider portions, the resist films 9 and 11 used for the formation of the gate electrode portions 3a and 3b can be easily aligned. This is very important because more delicate alignment is required as the width of the interconnection between the electrodes is smaller. Moreover, when the joint portions 3c and 3d are wider, the contact hole 8 formed on the joint portions 3c and 3d can be sufficiently large even when the remaining portions of the gate electrode portions 3a and 3b are narrower. With the large contact hole, the resistance thereof can be reduced. Accordingly, forming the joint portions 3c and 3d having a width greater than the other portions of the gate electrode portions 3a and 3b is advantageous both for the formation of the gate electrode 3 and the formation of the contact hole 8.

Assuming that the alignment accuracy of a stepper used for the photolithographic process is within ±0.5 µm and the accuracy of the mask is within ±1 µm. When the gate electrode 3 is formed using this stepper, the width of the joint portions 3c and 3d is preferably greater than that of the remaining portions of the gate electrode portions 3a and 3b by 1.5 µm or more. Also, assuming that the alignment accuracy of an aligner used for the photolithographic process is within ±3 µm and the accuracy of the mask is within 1 µm. When the gate electrode 3 is formed using this aligner, the width of the joint portions 3c and 3d is preferably greater than that of the remaining portions of the gate electrode portions 3a and 3b by 4 µm or more.

In order to form the gate electrode 3 having the shape as shown in Figure 12, the resist film 9 should have a pattern as shown in Figure 13 in which the width of a portion 9c thereof corresponding to the joint portion 3c is greater than that of a portion 9c' thereof corresponding to the remaining portion of the gate electrode portion 3a. Likewise, the resist film 11 should have a pattern as shown in Figure 14 in which the width of a portion 11d thereof corresponding to the joint portion 3d is greater than that of a portion 11d' thereof corresponding to the remaining portion of the gate electrode portion 3b. The resist film 11 with the above shape should be formed so that it would not overlap the resist film 9 if the resist film 9 had not been removed, except for the wider portion 11d. This ensures that there exists no unnecessary electrode portion (a portion left unetched) around the joint portions 3c and 3d.

As shown in Figure 11E, after the formation of the gate electrode 3, an interlevel insulating film 113 having a thickness of 500 nm, for example, is formed covering the semiconductor layers 1 and 2 and the gate electrode 3. The contact holes 4 to 8 are formed through the interlevel insulating film 113. The contact holes 4 and 5 are formed so as to reach the p⁺-type source region 1a and the p⁺-type drain region lb, respectively. The contact holes 6 and 7 are formed so as to reach the n⁺-type source region 2a and the n⁺-type drain region 2b, respectively. The contact hole 8 is formed so as to reach the gate electrode 3. Then, as shown in Figure 11F, conductive material such as metal is deposited on the interlevel insulating film 113 burying the contact holes 4 to 8, thus forming an electrode 114. The electrode 114 is used as an external wire connection for electrically connecting the TFT pair to an outer circuit (not shown).

In the illustrated example, the gate electrode is made of polysilicon doped with either p-type or n-type impurity atoms. Alternatively, the gate electrode may be made of metal such as tungsten, titanium, molybdenum, and the like having a high melting point, including a silicide thereof. Aluminum may also be used, which is advantageous in having a lower resistance than the former metals having a high melting point.

### Example 2

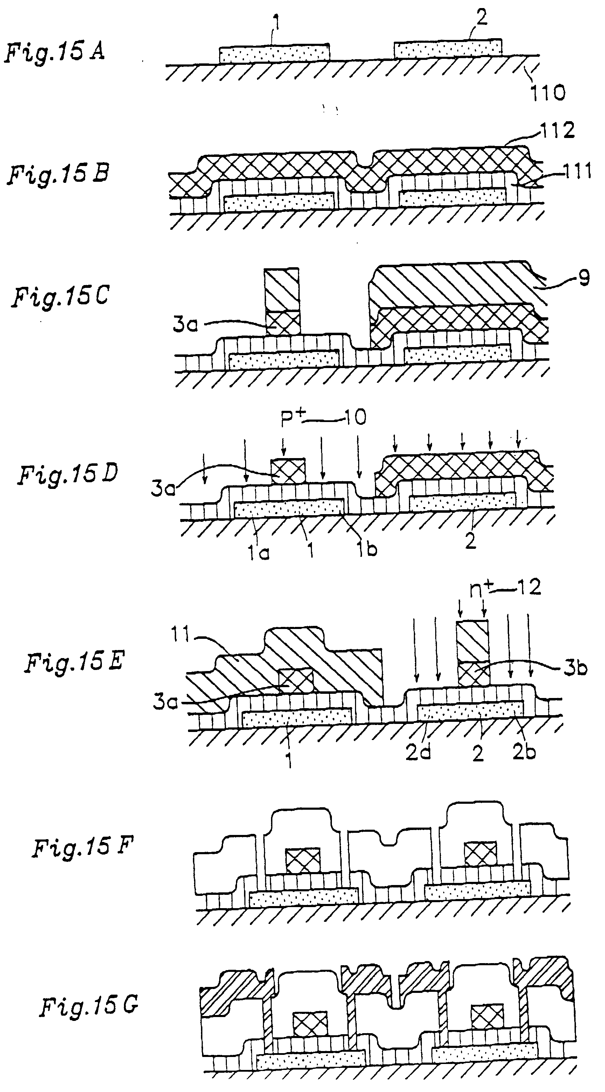

A second example of the fabricating process according to the present invention will be described with reference to Figures 15A to 15G as follows:

Figures 15A and 15B are the same as Figures 11A and 11B of Example 1. That is, after the formation of semiconductor layers 1 and 2 on a transparent insulating substrate 110, a gate insulating film 111 and a gate material film 112 are formed. The gate material film 112 is made of polysilicon doped with either p-type or n-type impurity atoms.

Then, a resist film 9 is formed on the gate material film 112 and patterned as shown in Figure 3 (hatched area) so as to cover an area allocated for a gate electrode portion 3a and at least an area allocated for a gate electrode portion 3b and the semiconductor layer 2. The resist film 9 can be formed, for example, by applying a positive resist on the entire surface of the gate material film 112, exposing the resist to light using a mask of the pattern shown by the hatched area in Figure 3, and developing the resist. Then, areas which are not covered with the resist film 9 are completely etched, thus forming the gate electrode portion 3a as shown in Figure 15C. The resist film 9 is then removed.

After the removal of the resist film 9, the semiconductor layer 1 is doped with impurity atoms of the same conductivity type as that of the gate electrode portion 3a by a first ion implantation or doping. Note that the gate electrode portion 3a is simultaneously doped with the impurity atoms since it is not covered with the resist film 9. As a result, a source region 1a and a drain region 1b of the same conductivity type as that of the gate electrode portion 3a are obtained. For example, when the gate electrode portion 3a has been doped with p-type impurity atoms, the semiconductor layer 1 is doped with p-type impurity atoms 10 as shown in Figure 15D. Boron can be used as the p-type impurity atoms 10.

Then, a resist film 11 is formed on the gate material film 112 and patterned as shown in Figure 4 (hatched area) so as to cover an area allocated for a gate electrode portion 3b and at least a gate electrode portion 3a and the semiconductor layer 1. The resist film 11 can be formed, for example, by applying a positive resist on the entire surface of the gate material film 112, exposing the resist to light using a mask of the pattern shown by the hatched area in Figure 4, and developing the resist. Then, areas which are not covered with the resist film 11 are completely etched, thus to form the gate electrode portion 3b. As a result, the gate electrode portions 3a and 3b are formed as a single continuous layer.

With the resist film 11 kept unremoved, a second ion implantation or doping is conducted in which the semiconductor layer 2 is doped with impurity atoms of the conductivity type different from the one used for the first ion implantation or doping. Since the gate electrode portion 3b is covered with the resist film 11, it is not doped with the impurity atoms during the second doping. Accordingly, the conductivity type of a source region 2a and a drain region 2b and that of the gate electrode portion 3b are different from each other. For example, when the gate electrode portion 3a has been doped with p-type impurity atoms, the semiconductor layer 2 is doped with n-type impurity atoms 12 as shown in Figure 15E. Phcsphorus can be used as the n-type impurity atoms 12. The resist film 11 is removed after the second ion implantation or doping.

Figures 15F and 15G are the same as Figures 11E and 11F of Example 1. Description on these steps is therefore omitted.

According to the fabricating process of this example, the gate electrode 3 is formed as a single continuous layer having the gate electrode portions 3a and 3b. As Example 1, the fabricating process of this example makes it possible to fabricate the TFT pair including the gate electrode made of polysilicon having a structure which can not be obtained by the conventional fabricating process. By Integrally forming the gate electrode, it is not necessary to form two contacts as conventionally required for connecting the two electrically-isolated gate electrodes through the metal inter connection. This reduces the number of contacts required for the TFT pair, and as a result lowering of the production yield caused by a contact defect can be prevented.

The fabricating process of this example is also advantageous in that one photolithographic process can be saved. This reduces the possibility of the occurrence of defects caused by the attachment of fine particles in the air to a mask used in the process. As a result, the production yield improves.

As in Example 1, the joint portions 3c and 3d of the gate electrode portions 3a and 3b have preferably a greater width than the remaining portions thereof, as shown in Figure 12.

In the illustrated example, the gate electrode is made of polysilicon doped with either p-type or n-type impurity atoms. Alternatively, the gate electrode may be made of metal or undoped polysilicon. Such metal includes tungsten, titanium, molybdenum, and the like having a high melting point, including a silicide thereof. Aluminum may also be used, which is advantageous in having a lower resistance than the former metals having a high melting point. When the metal or undoped polysilicon is used as the material of the gate electrode, the semiconductor 1 is doped with either p-type or n-type impurity atoms during the first ion implantation or doping shown in Figure 15D. The subsequent steps are the same as those described above. For example, when the semiconductor layer 1 is doped with n-type impurity atoms at the first ion implantation or doping, the semiconductor layer 2 should be doped with p-type impurity atoms.

### Example 3

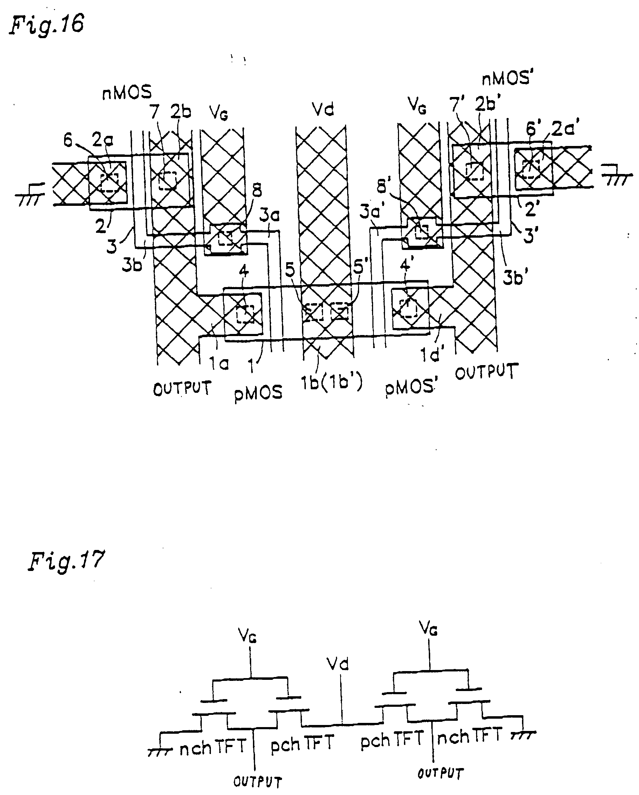

Figure 16 is a plan view showing two TFT pairs each having a CMOS structure. Each of the two TFT pairs corresponds to the TFT pair shown in Figure 1. Components constituting one of the two TFT pairs are denoted by the same reference numerals as those for the corresponding components shown in Figure 1, while components constituting the other TFT pair are denoted by adding '(dash) to the corresponding reference numerals.

As shown in Figure 16, two PMOS transistors are formed on a semiconductor layer 1. These PMOS transistors have a common drain region 1b (1b'), and the two TFT pairs are disposed symmetrical to each other with regard to the drain region 1b. Figure 17 is a circuit diagram of the two TFT pairsshown in Figure 16.

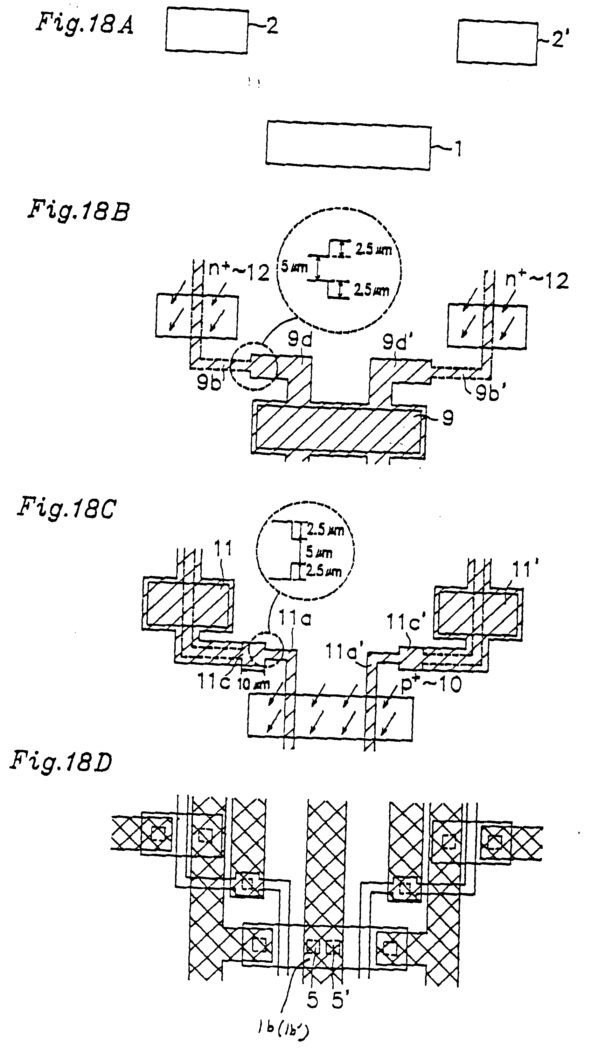

The process for fabricating the two TFT pairs by a stepper will be described step by step with reference to Figures 18A and 18D. Assuming that alignment accuracy of the stepper is within ±0.5 µm and the accuracy of the mask is within ±1 µm.

Referring to Figure 18A, three semiconductor layers 1, 2, and 2' are formed on a transparent insulating substrate (not shown). For example, the semiconductor layer 1 has a size of 5-100 µm in a longitudinal direction and 60-65 µm in a lateral direction. The semiconductor layers 2 and 2' are respectively formed at positions apart from the semiconductor layer 1 by approximately 20 µm in the longitudinal direction and approximately 5-10 µm in the lateral direction. Then, a gate insulating film (not shown) is formed so as to cover the semiconductor layers 1, 2, and 2'.

A gate material film (not shown) is formed on the gate insulating film. The gate material film is made of polysilicon doped with either p-type or n-type impurity atoms. Then, a resist film 9 is formed on the gate material film and patterned as shown in Figure 18B (hatched area) so as to cover areas allocated for gate electrode portions 3b and 3b' and at least areas allocated for gate electrode portions 3a and 3a' and the semiconductor layer 1. When portions 9b and 9b' of the resist film 9 respectively corresponding to the gate electrode portions 3b and 3b' are 5 µm wide, for example, portions 9d and 9d' of the resist film 9 respectively corresponding to joint portions 3d and 3d' can be wider by 2.5 µm on each side. As a result, the width of the portions 9d and 9d' can be 10 µm. Thereafter, portions of the gate material film which are not covered with the resist film 9 are completely etched, thereby forming the date electrode portions 3b and 3b'.

With the resist film 9 kept unremoved, the semiconductor layers 2 and 2' are doped with n-type impurity atoms by a first ion implantation or doping, as shown in Figure 18B. As a result, an n⁺-type source region 2a and an n⁺-type drain region 2b are formed in the semiconductor layer 2, and an n⁺-type source region 2a' and an n⁺-type drain region 2b' are formed in the semiconductor layer 2'. The resist film 9 is removed after the first ion implantation or doping.

Thereafter, resist films 11 and 11' are formed on the gate material film and patterned as shown in Figure 18C (hatched area). The resist film 11 covers an area allocated for the gate electrode portion 3a and at least the gate electrode portion 3b and the semiconductor layer 2. The resist film 11' covers an area allocated for the gate electrode portion 3a' and at least the gate electrode portion 3b' and the semiconductor layer 2'. When portions 11a and 11a' of the resist film 11 respectively corresponding to the gate electrode portions 3a and 3a' are 5 µm wide, for example, portions 11c and 11c' of the resist film 11 respectively corresponding to joint portions 3c and 3c' can be wider by 2.5 µm on each side. As a result, the width of the portions 11c and 11c' can be 10 µm.

The resist films 11 and 11' should be formed so that they do not overlap the resist film 9 if the resist film 9 has not been removed, except for the wider portions 11c and 11c'. For example, the portions 11c and 11c' may overlap the resist film 9 by a length of 10 µm. This results in the formation of gate electrode portions having a size of 10 µm x 10 µm at the joint of the gate electrode portions 3a and 3b and at the joint of the gate electrode portions 3a' and 3b', respectively.

Thereafter, portions of the gate material film which are not covered with the resist films 11 and 11' are completely etched, thereby forming the gate electrode portions 3a and 3a'. Thus, the gate electrode portions 3a and 3b are formed as a single continuous layer as the gate electrode 3, and the gate electrode portions 3a' and 3b' are formed as a single continuous layer as the gate electrode 3'.

With the resist films 11 and 11' kept unremoved, the semiconductor layer 1 is doped with p-type impurity atoms 10 by a second ion implantation or doping, as shown in Figure 18C. As a result, a p⁺-type source regions 1a and 1a' and a p⁺-type drain region 1b (1b') are formed on the semiconductor layer 1. The resist films 11 and 11' are removed after the second ion implantation or doping.

An interlevel insulating film (not shown) covering the semiconductor layers 1, 2, and 2' and the gate electrodes 3 and 3' is formed. Then, as shown in Figure 18D, contact holes and electrodes (hatched areas in Figure 18D) are formed. The size of each contact hole may be 3 µm x 3 µm, and the width of each electrode may be 12 µm. Though two contact holes 5 and 5' are formed so as to reach the drain region 1b (1b') in Figure 18D, only one contact hole may be formed so as to reach the drain region 1b (1b') since the drain region 1b (1b') is shared by the two PMOS transistors.

Thus, according to the fabricating process of this example, the gate electrode 3 is formed as a single continuous layer having the gate electrode portions 3a and 3b, and the gate electrode 3' is formed as a single continuous layer having the gate electrode portions 3a' and 3b'. The fabricating process of this example, as those of the previous examples, makes it possible to fabricate the TFT pair including the gate electrode made of polysilicon having a structure which can not be obtained by the conventional fabricating process. By integrally forming the gate electroda, it is not necessary to form two contacts as conventionally required for connecting the two electrically-isolated gate electrodes through the metal interconnection. This reduces the number of contacts required for the TFT pair, and as a result lowering of the production yield caused by a contact defect can be prevented.

Another advantage of the fabricating process of this example is that one photolithographic process can be saved. This reduces the possibility of the occurrence of defects caused by the attachment of fine particles in the air to a mask used during the process. As a result, the production yield improves.

In the illustrated example, the gate electrode is made of polysilicon doped with either p-type or n-type impurity atoms. Alternatively, the gate electrode may be made of metal or undoped polysilicon. Such metal includes tungsten, titanium, molybdenum, and the like having a high melting point, including a silicide thereof. Aluminum may also be used, which is advantageous in having a lower resistance than the former metals having a high melting point.

### Example 4

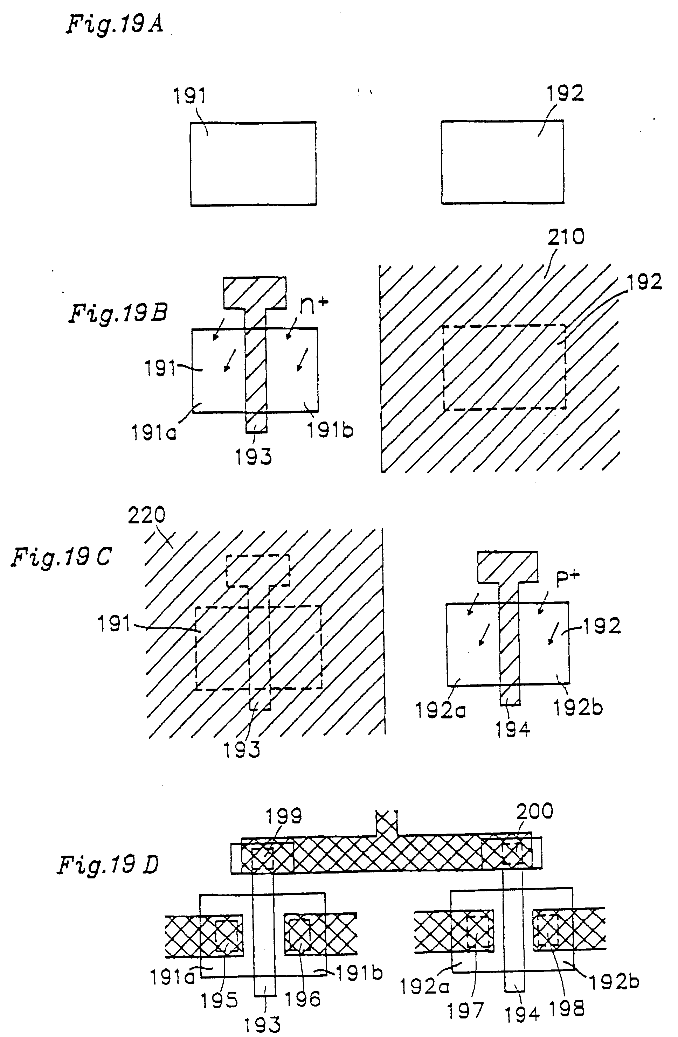

This example illustrates a process for fabricating a TFT pair having separate gate electrodes with reference to Figures 19A to 19D.

As shown in Figure 19A, two semiconductor layers 191 and 192 are formed on a transparent insulating substrate (not shown). The semiconductor layers 191 and 192 are then covered with a gate insulating film (not shown). A gate material film (not shown) is formed on the gate insulating film. The gate material film is made of polysilicon doped with either p-type or n-type impurity atoms.

A resist film 210 is formed on the gate material film and patterned as shown in Figure 19B (hatched areas) so as to cover an area allocated for a gate electrode 193 and at least the semiconductor layer 192. Then, areas which are not covered with the resist film 210 are completely etched, thus to form the gate electrode 193.

With the resist film 210 kept unremoved, the semiconductor layer 191 is doped with either p-type or n-type impurity atoms by a first ion implantation or doping. For example, the semiconductor layer 191 can be doped with n-type impurity atoms, as shown in Figure 19B, thus forming an n⁺-type source region 191a and an n⁺-type drain region 191b in the semiconductor layer 191. The resist film 210 is removed after the first ion implantation or doping.

Thereafter, a resist film 220 is formed on the gate material film and patterned as shown in Figure 19C so as to cover an area allocated for a gate electrode 194 and at least the semiconductor layer 191. The resist film 220 should be formed so that it would not overlap the resist film 210 if the resist film 210 had not been removed. This ensures that no unnecessary electrode portion is formed. Then, areas which are not covered with the resist film 220 are completely etched, thus forming the gate electrode 194.

With the resist film 220 kept unremoved, a second ion implantation or doping is conducted in which the semiconductor layer 192 is doped with impurity atoms of the conductivity type different from the one used for the first ion implantation or doping. For example, the semiconductor layer 192 can be doped with p-type impurity atoms as shown in Figure 19C, thus forming a p + -type source region 192a and a p⁺-type drain region 192b. The resist film 220 is removed after the second ion implantation or doping.

An interlevel insulating film (not shown) covering the semiconductor layers 191 and 192 and the gate electrodes 193 and 194 is formed. Then, as shown in Figure 19D, contact holes and electrodes (hatched areas in Figure 19D) are formed.

According to the method of this example, though the resultant TFT pair has the same structure as that of the conventional TFT pair, one photolithographic process can be saved. This reduces the possibility of the occurrence of defects due to the attachment of fine particles in the air to a mask used during the process, and as a result, the production yield improves.

In the illustrated example, the gate electrode is made of polysilicon doped with either p-type or n-type impurity atoms. Alternatively, the gate electrode may be made of metal or undoped polysilicon. Such metal includes tungsten, titanium, molybdenum, and the like having a high melting point, including a silicide thereof. Aluminum may also be used, which is advantageous in having a lower resistance than the former metals having a high melting point.

In the above-described examples, the semiconductor layers made of polysilicon are doped with impurities by the following methods:

A first method is an ion doping utilizing self activation of impurities. According to this method, impurities implanted into the polysilicon are activated by a sufficient amount of hydrogen ions provided during the ion implantation. By this activation, a high-temperature annealing process after the ion implantation can be omitted. This means that the temperature can be kept as low as approximately 450°C or less through the process of forming the source and drain regions. As a result, metal having a comparatively low melting point can be used as the material of the gate electrode, in addition to the conventional polysilicon doped/undoped with impurity atoms. Therefore, this method is advantageous in that aluminum having a low melting point can be used as the material of the gate electrode. Examples of the conditions for the ion implantation according to this method are as follows:

When an n-channel TFT is fabricated, phospho- rus ions are implanted into a semiconductor layer together with hydrogen ions at an implantation energy of 88 KeV so as to obtain a dose of phosphorus of 6 x 10¹⁵ ions/cm². When a p-channel TFT is fabricated, boron ions are implanted into a semiconductor layer together with hydrogen ions at an implantation energy of 31 KeV so as to obtain a dose of boron of 6 x 10¹⁵ ions/cm². In order to generate hydrogen ions, the concentration of hydrogen contained in the material gas is 80% or more.

The second method is an ion doping not utilizing self activation of impurities. According to this method, since a high-temperature annealing process is required, a metal having a low melting point such as aluminum can not be used. Examples of the conditions for the ion implantation according to this method are as follows:

When an n-channel TFT is fabricated, phosphorus ions are implanted into a semiconductor layer together with hydrogen ions at an implantation energy of 88 KeV so as to obtain a dose of phosphorus of 2 x 10¹⁵ ions/cm² When a p-channel TFT is fabricated, boron ions are implanted into a semiconductor layer together with hydrogen ions at an implantation energy of 31 KeV so as to obtain a dose of boron of 2 x 10¹⁵ ions/cm2. In order to generate hydrogen ions, the concentration of hydrogen contained in the material gas is 80% or more. The ratios of doses of phosphorus ions and boron ions to hydrogen ions are the same as those employed in the first method.

Other doping methods include general ion implantation methods, which normally require a high-temperature annealing process. Therefore, the use of a metal having a low melting point such as aluminum is not possible.

Thus, according to the process for fabricating a TFT pair of the present invention, a resist film used for the formation of a gate electrode can also be used for the formation of a source region and a drain region. Moreover, the resist film used for the formation of the gate electrode can also be used to protect a source region and a drain region which should be of one of the conductivity types from being doped with impurities of the other conductivity type. This reduces the number of photomasks and the number of photolithographic processes required for the process for fabricating the TFT pair.

According to the fabricating processes of Examples 1, 3, and 4, polysilicon previously doped with either p-type or n-type impurity atoms can be used as the material of the gate electrode. The gate electrode is covered with a resist film when the source and drain regions are formed by ion implantation or other doping methods. As a result, the gate electrode is prevented from being doped with impurity atoms having a conductivity type different from the one of the previously doped impurity atoms. The conductivity of the gate electrode is thus protected from being lowered.

According to the fabricating process of Example 2, polysilicon previously doped with either p-type or n-type impurity atoms can be used as the material of the gate electrode. When the source and drain regions are formed by ion implantation or other doping methods, the gate electrode is doped with impurity atoms of the same conductivity type as that of the previously doped impurity atoms. As a result, the gate electrode is prevented from Including portions doped with impurity atoms having a conductivity type different from the one of the previously doped impurity atoms. The same effect can be obtained when undoped polysilicon is used as the material of the gate electrode. The conductivity of the gate electrode is thus protected from being lowered.

Further, according to the fabricating processes of Examples 1 to 3, two contacts conventionally required for connecting the two electrically-isolated gate electrodes through a metal interconnection are not necessary. This reduces the number of contacts required for the TFT pair, and as a result lowering of the production yield caused by a contact defect can be prevented.

Due to the above-described reasons, the operation efficiency during the fabricating process and the production yield of the resultant TFT pairs are improved.

The TFT pair of the present invention includes a gate electrode having a first gate electrode portion and a second gate electrode portion. The first gate electrode portion includes the first joint portion having a width greater than that of the remaining portion thereof. The second gate electrode portion includes a second joint portion having a width greater than that of the remaining portion thereof. The first and second Joint portions are connected to each other. The first gate electrode portion with the first joint portion and the second gate electrode portion with the second joint portion-constitute a single continuous layer. This structure is advantageous in that the resist films used in the above-described fabricating process can be easily aligned. Further, by forming a contact hole on the widened first and second joint portions, the contact resistance can be reduced regardless of the width of the remaining portions of the first and second gate portions.

Various other modifications will be apparent to and can be readily made by those skilled in the art without departing from the scope and spirit of this invention. Accordingly, it is not intended that the scope of the claims appended hereto be limited to the description as set forth herein, but rather that the claims be broadly construed.

## Claims

1. A thin film transistor pair comprising:
a substrate;
a first semiconductor layer formed on said substrate, said first semiconductor layer having a source region of a first conductivity type, a drain region of said first conductivity type, and a channel region interposed between said source region and said drain region;
a second semiconductor layer formed on said substrate at a position apart from said first semiconductor layer, said second semiconductor layer having a source region of a second conductivity type, a drain region of said second conductivity type, and a channel region interposed between said source region and said drain region;
a gate insulating film covering said first semiconductor layer and said second semiconductor layer; and
a gate electrode formed on said gate insulating film, said gate electrode having a first gate portion covering said channel region of said first semiconductor layer and a second gate portion covering said channel region of said second semiconductor layer,
wherein said first gate portion of said gate electrode has a first joint portion having a width greater than that of the remaining portion of said first gate portion, and said second gate portion of said gate electrode has a second joint portion having a width greater than that of the remaining portion of said second gate portion, said first and second joint portions being connected to each other, and
wherein said first gate portion with said first joint portion and said second gate portion with said second joint portion constitute a single continuous layer.

2. A thin film transistor pair comprising:
a substrate;
a first semiconductor layer formed on said substrate, said first semiconductor layer having a source region of a first conductivity type, a drain region of said first conductivity type, and a channel region interposed between said source region and said drain region;
a second semiconductor layer formed on said substrate at a position apart from said first semiconductor layer, said second semiconductor layer having a source region of a second conductivity type, a drain region of said second conductivity type, and a channel region interposed between said source region and said drain region;
a gate insulating film covering said first semiconductor layer and said second semiconductor layer; and
a gate electrode formed on said gate insulating film, said gate electrode having a first gate portion covering said channel region of said first semiconductor layer and a second gate portion covering said channel region of said second semiconductor layer,
wherein said first gate portion and said second gate portion constitute a single continuous layer, and
said gate electrode is made of polysilicon doped with impurity atoms of substantially one of said first conductivity type and said second conductivity type.

3. A process for fabricating a thin film transistor pair, said thin film transistor pair including:
a substrate;
a first semiconductor layer formed on said substrate;
a second semiconductor layer formed on said substrate at a position apart from said first semiconductor layer;
a gate insulating film covering said first semiconductor layer and said second semiconductor layer; and
a gate electrode formed on said gate insulating film, said gate electrode having a first gate portion covering a channel region of said first semiconductor layer and a second gate portion covering a channel region of said second semiconductor layer,
said process comprising the steps of:
forming said first semiconductor layer and said second semiconductor layer on said substrate;
forming said insulating film covering said first semiconductor layer and said second semiconductor layer;
forming a gate material film on said gate insulating film;
forming a first resist film on said gate material film, said first resist film being patterned to cover a portion allocated for said first gate portion and at least a portion allocated for said second gate portion and said second semiconductor layer;
forming said first gate portion by etching said gate material film using said first resist film as a mask;
doping a portion of said first semiconductor layer not covered with said first gate portion with impurity atoms of a first conductivity type before the removal of said first resist film so as to form a source region and a drain region in said first semiconductor layer;
removing said first resist film;
forming a second resist film patterned to cover at least said first gate portion and said first semiconductor layer and a portion allocated for said second gate portion of said gate material film;
forming said second gate portion by etching said gate material film using said second resist film as a mask;
doping a portion of said second semiconductor layer not covered with said second gate portion with impurity atoms of a second conductivity type before the removal of said second resist film so as to form a source region and a drain region in said second semiconductor layer; and
removing said second resist film.

4. A process according to claim 3, wherein said gate material film is made of polysilicon doped with impurity atoms of one of said first conductivity type and said second conductivity type.

5. A process according to claim 3, wherein said gate material film is made of metal.

6. A process according to claim 3, wherein said first gate portion and said second gate portion constitute a single continuous layer.

7. A process for fabricating a thin film transistor pair, said thin film transistor pair including:
a substrate;
a first semiconductor layer formed on said substrate;
a second semiconductor layer formed on said substrate at a Position apart from said first semiconductor layer;
a gate insulating film covering said first semiconductor layer and said second semiconductor layer; and
a gate electrode formed on said gate insulating film, said gate electrode having a first gate portion covering a channel region of said first semiconductor layer and a second gate portion covering a channel region of said second semiconductor layer,
said process comprising the steps of:
forming said first semiconductor layer and said second semiconductor layer on said substrate;
forming said insulating film covering said first semiconductor layer and said second semiconductor layer;
forming a gate material film on said gate insulating film;
forming a first resist film on said gate material film, said first resist film being patterned to cover a portion allocated for said first gate portion and at least a portion allocated for said second gate portion and said second semiconductor layer;
forming said first gate portion by etching said gate material film using said first resist film as a mask;
removing said first resist film;
doping a portion of said first semiconductor layer not covered with said first gate portion with impurity atoms of a first conductivity type after the removal of said first resist film so as to form source region and a drain region in said first semiconductor layer;
forming a second resist film patterned to cover at least said first gate portion and said first semiconductor layer and a portion allocated for said second gate portion of said gate material film;
forming said second gate portion by etching said gate material film using said second resist film as a mask;
doping a portion of said second semiconductor layer not covered With said second gate portion with impurity atoms of a second conductivity type before the removal of said second resist film so as to form a source region and a drain region in said second semiconductor layer; and
removing said second resist film.

8. A process according to claim 7, wherein said gate material film is made of polysilicon doped with impurity atoms of said first conductivity type.

9. A process according to claim 7, wherein said gate material film is made of metal.

10. A process according to claim 7, wherein said gate material film is made of polysilicon undoped with impurity atoms.

11. A process according to claim 7, wherein said first gate portion and said second gate portion constitute a single continuous layer.

12. A thin film transistor pair comprising:
a substrate;
a first semiconductor layer formed on said substrate;
a second semiconductor layer formed on said substrate at a position apart from said first semiconductor layer;
a gate insulting film covering said first semiconductor layer and said second semiconductor layer; and
a gate electrode formed on said gate insulating film, said gate electrode having a first gate portion covering a channel region of said first semiconductor layer and a second gate portion covering a channel region of said second semiconductor layer,
wherein said first and second gate portions are connected to each other, and constitute a single continuous layer.

13. A thin film transistor pair according to claim 12, further including an insulating film covering said first and second semiconductor layers and said gate electrode, said insulating film including source and drain contact holes reaching source regions and drain regions of said first and second semiconductor layers; and a gate contact hole reaching said single continuous layer to enable a single contact to be made through said gate contact hole to said interconnected first and second gate portions.

14. A method of forming a thin film transistor pair on a substrate, each transistor comprising a respective semiconductor layer with source, drain and channel regions and a gate electrode portion over said channel region with a gate insulating film disposed therebetween, the method including doping the source and drain regions of the semiconductor layers with impurity atoms of one conductivity type for one of said transistors and of the opposite conductivity type for the other of said transistors, wherein at least one of the two doping operations is effected while a resist pattern used in the formation of the gate electrode portion of the relevant transistor still covers that formed gate electrode portion and the source and drain regions of the other semiconductor layer.
